# EUROPEAN PATENT SPECIFICATION

(11) **EP 4 282 234 B1**
(45) Date of publication and mention of the grant of the patent: **01.04.2026**
(21) Application number: 21701883.7
(22) Date of filing: 21.01.2021
(51) Int. Cl.: H05K 7/20, H01L 23/473

(54) **A METHOD FOR COOLING HEAT GENERATING POWER ELECTRONICS AND A COOLING DEVICE**
VERFAHREN ZUR KÜHLUNG VON WÄRMEERZEUGENDER LEISTUNGSELEKTRONIK UND KÜHLVORRICHTUNG
PROCÉDÉ DE REFROIDISSEMENT D'ELECTRONIQUE DE PUISSANCE GENERATRICE DE CHALEUR ET DISPOSITIF DE REFROIDISSEMENT

(43) Date of publication of application: 29.11.2023
(73) Proprietor: Hydraspecma AS, 6900 Skjern (DK)
(72) Inventor: STUBKIER, Søren Imer, 8600 Silkeborg (DK); OLESEN, Martin Frølich, 8632 Lemming (DK); OLSZEWSKA, Karina, Aarhus V 8210 (DK); NØRLØV, Anders Dyhr, 8362 Hørning (DK)
(74) Representative: Patentgruppen A/S
(86) International application number: PCT/DK2021/050021
(87) International publication number: WO 2022/156865

(56) References cited:
- WO-A1-2012/114475
- US-A1- 2012 012 295
- US-A1- 2017 164 516

## Description

### Field of the Invention

The present invention relates to a method for cooling at least one heat generating power electronics by means of a turbulator placed in a cavity of a baseplate. The invention further relates to a cooling device.

### Background of the Invention

Power electronics such as rectifiers, inverters, converters, semiconductors, transistors and other often generates much heat during use and it is therefore known to cool these devices to ensure their function and to prevent damage.

From EP 2 207 201 B1 it is known to place an electronic component that requires cooling on top of a plate where the bottom side of the plate is cooled by liquid which is guided along the plate by means of a distributing element. But the heat transfer in such an arrangement is not particularly efficient.

Thus, from US 9,638,477 B1 it is known to place an electronic device on a plate comprising a turbulator extending from the bottom of the plate. The plate is then positioned on a manifold so that the turbulator extends down into a cavity in the manifold, and a flow of cooling liquid is established in the cavity. Forming the turbulator integrally with the plate ensures good heat conductivity but this design is complex and costly.

From WO 2012/114475 A1 a cooler device is known in which a coolant flows to a fin member disposed between a top plate and a cooling case, wherein a rubber piece is assembled to the tip of each pin fin of the fin member so that the rubber pieces are elastically deformed when pressed against the lower wall surface of the cooling case. However, such a design is complex and costly, and the rubber pieces will deteriorate over time.

It is therefore an object of the present invention to provide for a more simple and cost-efficient technique for cooling heat generating power electronics.

### The invention

The invention relates to a method for cooling at least one heat generating power electronics. The method comprises the steps of
- forming at least one cavity in a baseplate so that the least one cavity is extending from a connection surface of the baseplate and into the baseplate,
- arranging a turbulator in the at least one cavity,
- connecting the at least one heat generating power electronics to the connection surface so that the at least one heat generating power electronics deforms the turbulator and forces the turbulator into the cavity, and
- generating a flow of cooling fluid through the cavity to cool the at least one heat generating power electronics
characterized in that,
the turbulator is extending out of the cavity so that the at least one heat generating power electronics deforms the turbulator and forces the turbulator into the cavity, or
at least a bottom part of the at least one heat generating power electronics is extending into the cavity, when the at least one heat generating power electronics is connected to the connection surface, so that the bottom part of the at least one heat generating power electronics deforms the turbulator and forces the turbulator into the cavity.

Forming the turbulator as a separate part is advantageous in that a turbulator having an efficient design in relation to generating turbulence in the flow of cooling fluid hereby can be manufactured in a separate process e.g., by punching, stamping or a similar process where the turbulator can be manufactured fast and efficiently in a simple mechanical process. And by connecting the heat generating power electronics to the connection surface so that the heat generating power electronics deforms and compresses the turbulator is advantageous in that the turbulator hereby presses firmly against the heat generating power electronics and the bottom of the cavity hereby ensuring good heat conduction between the heat generating power electronics and the turbulator while at the same time ensuring that the cooling fluid cannot flow over or under the turbulator - i.e. all the cooling fluid is guided through the turbulator thus increasing the efficiency of the cooling device to which the heat generating power electronics is attached.

Forming the turbulator so that it is slightly higher than the depth of the cavity and thereby is extending out of the cavity is advantageous in that heat generating power electronics with a flat bottom side hereby will compress the turbulator when the bottom part of the heat generating power electronics is connected tightly to the connection surface - i.e., this ensures a simple design of the heat generating power electronics.

Forming the heat generating power electronics so that a bottom part is projecting into the cavity and thereby compresses and deforms the turbulator when the heat generating power electronics is connected to the connection surface is advantageous in that turbulators that are slightly lower than the depth of the cavity hereby also can be compressed to ensure good heat conduction between the cooling fluid, the turbulator and the heat generating power electronics.

In an aspect, the method further comprises the step of arranging a gasket between the heat generating power electronics and the baseplate.

Arranging a gasket between the heat generating power electronics and the baseplate is advantageous in that this reduces the risk of the cooling fluid leaking out between the heat generating power electronics and the baseplate.

In an aspect, the at least one heat generating power electronics is connected tightly to the baseplate.

Connecting the heat generating power electronics tightly to the baseplate is advantageous in that this reduces the risk of the cooling fluid leaking out between the heat generating power electronics and the baseplate, and it ensure good heat conduction between the baseplate and the heat generating power electronics.

**In** an aspect, the at least one heat generating power electronics comprises a contact face arranged to be connected to the connection surface and wherein the bottom part is protruding from the contact face.

Hereby is achieved an advantageous embodiment of the invention.

**In** an aspect, at least a part of the connection surface is sloping downwards towards the at least one cavity so that at least a part of the at least one heat generating power electronics is bend in a downward arc, whereby the at least one heat generating power electronics deforms the turbulator and forces the turbulator into the cavity, when the at least one heat generating power electronics is connected to the connection surface.

Forming at least some of the connection surface around the cavity so that it is sloping downwards towards the cavity is advantageous in that this will entail that the heat generating power electronics is at least slightly bend downwards across the cavity whereby the heat generating power electronics deforms and compresses the turbulator when the heat generating power electronics is connected to the connection surface. This is advantageous in that it hereby in a simple manner is ensured that the heat generating power electronics presses firmly against the turbulator and in that this modification is easy to make on existing cooling systems simply by machining the edges around the cavities.

In an aspect, the at least one heat generating power electronics is connected to the connection surface by means of at least one connection means.

Connecting the heat generating power electronics to the connection surface by means of connection means is advantageous in that the heat generating power electronics hereby can be easily connected and disconnected.

It should be noticed, that in this context the term "connection means" should be understood as any kind of connector suited for connecting heat generating power electronics to a connection surface. I.e., the term includes any kind of screws, bolts, rivets or other.

In an aspect, the at least one connection means comprises bolts.

Connecting the heat generating power electronics to the connection surface by means of bolts is advantageous in that bolts are excellent for generating the downward force needed to compress the turbulator and form a tight connection between the heat generating power electronics and the connection surface.

In an aspect, the at least one heat generating power electronics fully covers the at least one cavity when the at least one heat generating power electronics is connected to the connection surface.

Forming the heat generating power electronics so that it fully covers the cavity when the heat generating power electronics is connected to the connection surface is advantageous in that no further sealing arrangement or other are needed.

Power electronics generates much heat and therefore needs efficient cooling, and it is therefore particularly advantageous to cool heat generating power electronics by means of the present invention. Furthermore, power electronics are relatively dimensionally stable and therefore suited for being cooled by a method according to the present invention.

In an aspect, the at least one heat generating power electronics comprises an intermediate plate.

Making the heat generating power electronics comprise an intermediate plate is advantageous in that this enables that e.g. delicate power electronics can be connected to the intermediate plate in one process and the more forceful connection of the intermediate plated to the connection surface can be performed in another separate process. Furthermore, the intermediate plate enables standardized connection of the heat generating power electronics on the connection surface even if e.g., the heat generating power electronics connected to the plate vary in design.

In an aspect, the method comprises the step of connecting the intermediate plate to the connection surface and subsequently connecting the power electronics to the intermediate plate.

Connecting the intermediate plate to the connection surface in a separate process is advantageous in that this hereby can be done by means of processes that might otherwise damage the power electronics - e.g., such as soldering or welding. Furthermore, this ensures that the power electronics can be replaced without exposing the cavity - i.e., without having to drain and refill the cooling fluid.

In an aspect, the method comprises the step of connecting the intermediate plate to the connection surface by means of soldering.

Soldering ensures a strong and tight connection that at the same time ensures good heat conduction.

In an aspect, the at least one heat generating power electronics deforms the turbulator so that the height of the turbulator is reduced by between 0,1% and 30%, preferably between 0,5% and 20% and most preferred between 1% and 10%.

If the turbulator is compressed too much its efficiency might be affected and it requires too much force to mount the heat generating power electronics. However, if the turbulator is compressed too little the heat conduction is reduced. Thus, the present hight reduction ranges present an advantageous relationship between usability and efficiency.

Furthermore, if the turbulator is compressed too much the turbulator might be plastically deformed - instead of just elastically deformed - which could affect the functionality of the turbulator if it was reused - i.e., if the heat generating power electronics was dismounted and remounted.

The invention further relates to a cooling device comprising a baseplate having at least one cavity extending from a connection surface of the baseplate and into the baseplate and wherein a cooling fluid channel connects the at least one cavity with a cooling fluid inlet and a cooling fluid outlet of the baseplate. The cooling device further comprises a turbulator arranged in the at least one cavity, and at least one heat generating power electronics being connected to the connection surface so that the at least one heat generating power electronics deforms the turbulator and forces the turbulator into the cavity. The cooling device is characterized in that,
the turbulator is extending out of the cavity so that the at least one heat generating power electronics deforms the turbulator and forces the turbulator into the cavity when the at least one heat generating power electronics is connected to the connection surface, or
at least a bottom part of the at least one heat generating power electronics is extending into the cavity, when the at least one heat generating power electronics is connected to the connection surface, so that the bottom part of the at least one heat generating power electronics deforms the turbulator and forces the turbulator into the cavity, when the at least one heat generating power electronics is connected to the connection surface.

Designing the cooling device and/or the heat generating power electronics so that the heat generating power electronics compresses the turbulator in the cavity is advantageous in that good heat conduction between the heat generating power electronics and the turbulator hereby is ensures while at the same time ensuring that the turbulator is correctly positioned in the cavity, so that all cooling fluid have to pass through the turbulator.

In an aspect, the at least one heat generating power electronics deforms the turbulator so that the height of the turbulator is reduced by between 0,1% and 30%, preferably between 0,5% and 20% and most preferred between 1% and 10% when the at least one heat generating power electronics is connected to the connection surface.

If the turbulator is compressed too much its efficiency might be affected and it requires too much force to mount the heat generating power electronics. However, if the turbulator is compressed too little the heat conduction is reduced. Thus, the present hight reduction ranges present an advantageous relationship between usability and efficiency.

In an aspect, the height of the turbulator is reduced by at least 0.1 millimeter when the at least one heat generating power electronics is connected to the connection surface.

Compressing the turbulator so that the height of the turbulator is reduced by at least 0.1 millimeter is advantageous in that this ensures that the tabulator presses firmly against the heat generating power electronics.

In an aspect, the height of the turbulator is reduced between 0.1 and 2 millimeters when the at least one heat generating power electronics is connected to the connection surface.

The present hight reduction range ensures that the tabulator presses firmly against the heat generating power electronics while at the same time ensuring that the efficiency of the turbulator is affected or that it requires too much force to mount the heat generating power electronics.

In an aspect, the cooling device further comprises a gasket encircling the at least one cavity.

Arranging a gasket between the heat generating power electronics and the baseplate all around the cavity is advantageous in that this reduces the risk of the cooling fluid leaking out between the heat generating power electronics and the baseplate.

In an aspect, the gasket is arranged in a baseplate groove in the connection surface or in heat generating power electronics grove in the heat generating power electronics.

Arranging the gasket in a groove in the connection surface or the heat generating power electronics is advantageous in that this ensures the correct position of the gasket is maintained at all times - thus, simplifying the mounting and dismounting procedure.

In an aspect, the hight of the turbulator is greater than the depth of the at least one cavity before the at least one heat generating power electronics is connected to the connection surface.

Forming the turbulator so that it is at least slightly higher than the depth of the cavity before the heat generating power electronics is connected to the connection surface is advantageous in that the turbulator thereby is extending out of the cavity whereby an heat generating power electronics with a flat bottom side will easily compress the turbulator when the bottom part of the heat generating power electronics is connected tightly to the connection surface - i.e., this ensures a simple design of the heat generating power electronics.

In an aspect, at least a part of the connection surface is sloping downwards towards the at least one cavity so that at least a part of the at least one heat generating power electronics is bend in a downward arc, whereby the at least one heat generating power electronics deforms the turbulator and forces the turbulator into the at least one cavity, when the at least one heat generating power electronics is connected to the connection surface.

Forming at least some of the connection surface around the cavity so that it is sloping downwards towards the cavity is advantageous in that this will entail that the heat generating power electronics is at least slightly bend downwards across the cavity whereby the heat generating power electronics deforms and compresses the turbulator when the heat generating power electronics is connected to the connection surface. This is advantageous in that it hereby in a simple manner is ensured that the heat generating power electronics presses firmly against the turbulator and in that this modification is easy to make on existing cooling systems simply by machining the edges around the cavities.

In an aspect, the baseplate comprises connection means for connecting the heat generating power electronics to the connection surface.

Connecting the heat generating power electronics to the connection surface by means of connection means is advantageous in that the heat generating power electronics hereby can be easily connected and disconnected.

In an aspect, the connection means comprises threaded holes.

Making the baseplate comprise threaded holes is advantageous in that a tight and forceful connection between the heat generating power electronics and the baseplate hereby can be made is a simple manner.

In an aspect, the turbulator is made of metal.

Forming the turbulator of metal is advantageous in that metal is an excellent conductor of heat.

In an aspect, the metal is aluminium.

Forming the turbulator of aluminium is advantageous in that aluminium is inexpensive, easy to machine and it is an excellent conductor of heat.

In an aspect, the turbulator is made of plastic.

Forming the turbulator of plastic is advantageous in such a turbulator is easy to manufacture even if it has a complex design and it is very inexpensive.

In an aspect, the baseplate is made of metal.

Forming the baseplate of metal is advantageous in that metal is an excellent conductor of heat.

In an aspect, the metal is aluminium.

Forming the baseplate of aluminium is advantageous in that aluminium is inexpensive, easy to machine and it is an excellent conductor of heat.

In an aspect, the at least one heat generating power electronics is connected to the connection surface by means of at least one connection means.

Connecting the heat generating power electronics to the connection surface by means of connection means is advantageous in that the heat generating power electronics hereby can be easily connected and disconnected.

In an aspect, the at least one connection means comprises bolts.

Connecting the heat generating power electronics to the connection surface by means of bolts is advantageous in that bolts are excellent for generating the downward force needed to compress the turbulator and form a tight connection between the heat generating power electronics and the connection surface.

In an aspect, the at least one heat generating power electronics comprises an intermediate plate.

Making the heat generating power electronics comprise an intermediate plate is advantageous in that this enables that e.g. delicate power electronics can be connected to the intermediate plate in one process and the more forceful connection of the intermediate plated to the connection surface can be performed in another separate process. Furthermore, the intermediate plate enables standardized connection of the heat generating power electronics on the connection surface even if e.g., the heat generating power electronics connected to the plate vary in design.

In an aspect, the intermediate plate is connected to the connection surface and the power electronics is connected to the intermediate plate.

Connecting the intermediate plate to the connection surface in a separate process is advantageous in that this hereby can be done by means of processes that might otherwise damage the power electronics - e.g., such as soldering or welding. Furthermore, this ensures that the power electronics can be replaced without exposing the cavity - i.e., without having to drain and refill the cooling fluid.

In an aspect, the intermediate plate is connected to the connection surface by means of soldering.

Soldering ensures a strong and tight connection that at the same time ensures good heat conduction.

### Figures

The invention will be explained further herein below with reference to the figures in which:
- fig. 1: shows a baseplate, as seen from the top,
- fig. 2: shows a cross section through a part of a baseplate, as seen from the front,
- fig. 3: shows a cross section through a part of a baseplate with turbulators extending out of the cavities, as seen from the front,
- fig. 4: shows a cross section through a cooling device with compressed turbulators, as seen from the front,
- fig. 5: shows a cross section through a cooling device with an intermediate plate, as seen from the front,
- fig. 6: shows a cross section through a cooling device with a gasket on the object, as seen from the front,
- fig. 7: shows a cross section through a cooling device with sloping edges on the baseplate, as seen from the front,
- fig. 8: shows a cross section through a cooling device with cooling paste on the objects, as seen from the front,
- fig. 9: shows a cooling device with continuous transverse cooling fluid flow, as seen from the top,
- fig. 10: shows a cooling device with continuous longitudinal cooling fluid flow, as seen from the top,
- fig. 11: shows a cooling device with individual transverse cooling fluid flow, as seen from the top, and
- fig. 12: shows a cooling device with cooling fluid inflow at the centre, as seen from the top.

### Detailed description

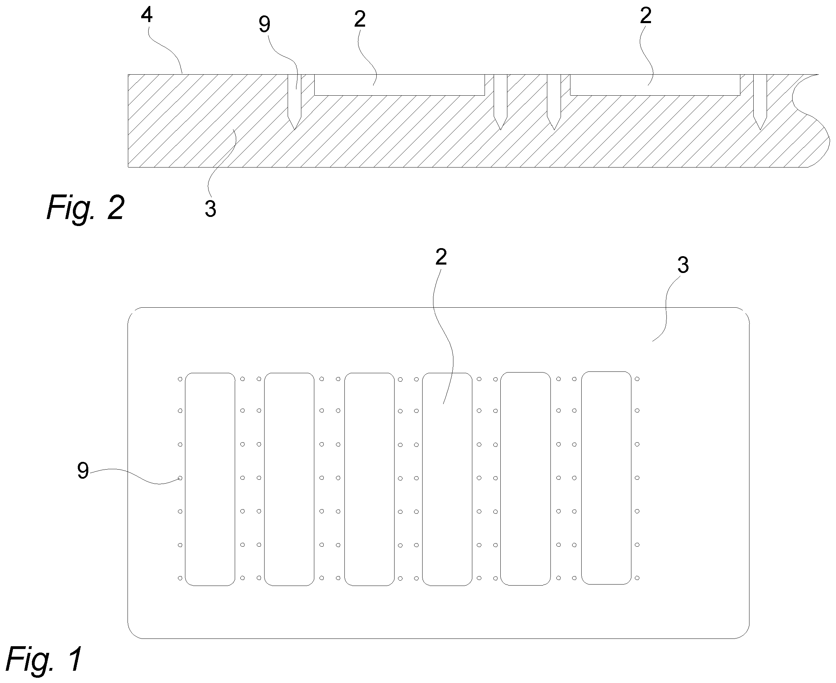

Fig. 1 shows a baseplate 3, as seen from top and fig. 2 shows a cross section through a part of a baseplate 3, as seen from the front.

In this embodiment the baseplate 3 is made from a single block of machined aluminium, but in another embodiment the baseplate 3 could be cast and/or the baseplate 3 could be made in from another material such as stainless steel, brass, cobber or another metal, the baseplate could be made from a composite material, ceramic or other or any combination of the above.

In this embodiment the baseplate 3 comprises six cavities 2 extending from the connection surface and down into the baseplate 3. However, in another embodiment the baseplate 3 could comprise another number of cavities 2 such as one, two, four, eight or even more. In this embodiment the cavities 2 are milled in the baseplate 3 but in another embodiment the cavities 2 could also or instead be formed by spark machining, drilling, stamping or other or any combination thereof or the cavities 2 could be formed in a casting process.

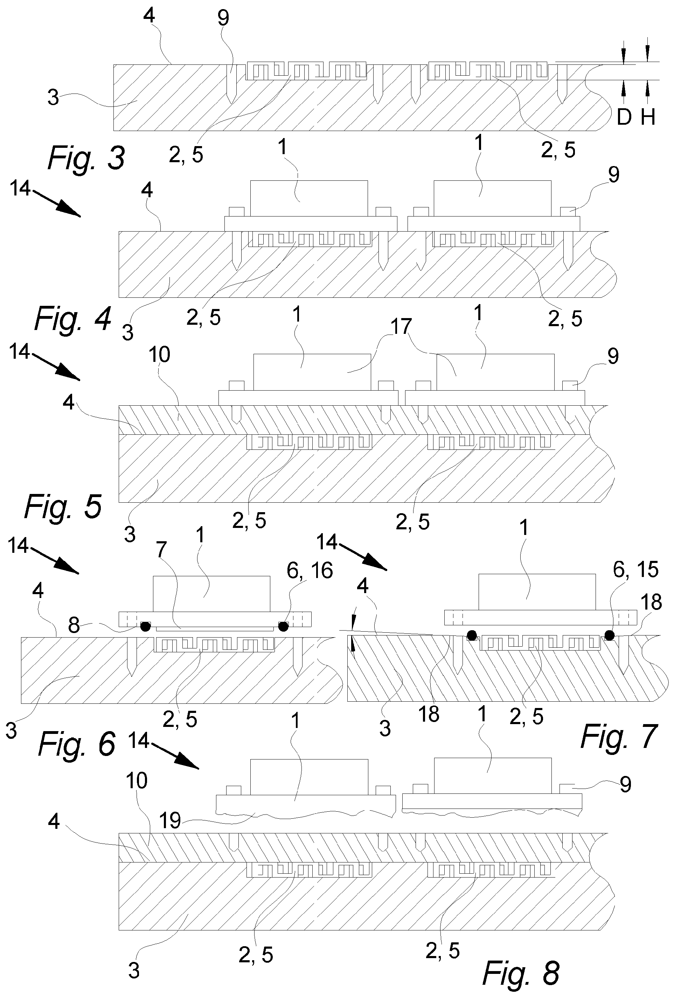

Fig. 3 shows a cross section through a part of a baseplate 3 with turbulators 5 extending out of the cavities 2, as seen from the front and Fig. 4 shows a cross section through the same cooling device 14 as disclosed in fig. 3 with compressed turbulators 5, as seen from the front.

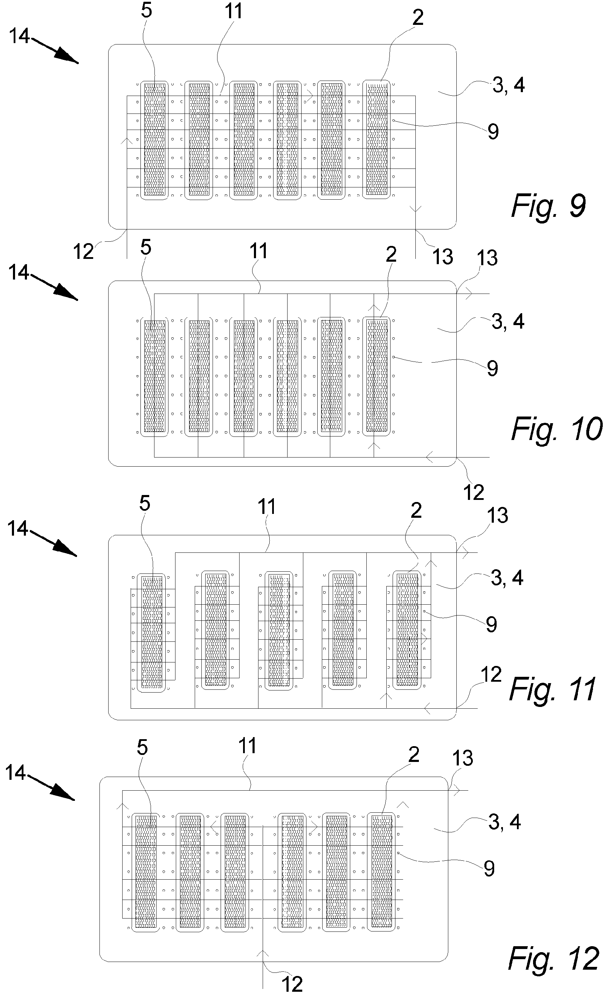

In this embodiment the cavities 2 are initially formed in the contact surface 4 of the baseplate 3 through milling. Connection means 9 in the form of threaded holes are also formed in the baseplate 3 along with a cooling fluid channel (not shown but discussed in relation to figs 9-12). A turbulator 5 is then arranged in each of the cavities 2 and in this embodiment the hight H of the turbulator 5 is greater than the depth D of the cavity 2 making the turbulator 5 extend out of the cavity 2 - i.e. the turbulator 5 is protruding slightly from the contact surface 4. In this embodiment the depth D of the cavity 2 is 4.7 millimetres and the hight H of the turbulator 5 is five millimetres making the turbulator 5 extend 0.3 millimetres out of the cavity 2. However, in another embodiment the difference between the depth D of the cavity 2 and the hight H of the turbulator 5 could be smaller such as 0.2 millimetres, 0.1 millimetres or even smaller or the difference could be greater such as 0.4 millimetres, 0.7 millimetres, 1.5 millimetres or even more e.g. depending on the specific use, the type of turbulator 5, the size of the object 1, the general size of the turbulator 5 or other.

The object 1 is then connected to the contact surface 4 by means of connection means 9 which in this embodiment is bolts extending through a hole in the object and into threaded holes in the baseplate 3. However, in another embodiment the connection means 9 could also or instead comprise a clamping device, adhesive, welding or other or any combination thereof.

In this embodiment the turbulator 5 is made from drawn aluminium sheet metal but in another embodiment the turbulator 5 could also or instead be made through casting, milling, 3D printing or other and/or the turbulator 5 could be made from cobber, stainless steel, brass, or another metal and/or the turbulator 5 could be made from a composite material, ceramic, plastic or other or any combination hereof.

The main function of the turbulator 5 is to turn laminar flow of the cooling fluid flowing through the cavity 2 into turbulent flow, in that a turbulent flow will mix up the cooling fluid as it passes through the cavity 2 and thereby increase the contact with the turbulator 5 and the object 1, whereby the heat exchange is increased. It should be noted that turbulators 5 can be made with a multitude of designs - e.g. with labyrinth channels, heat sink ribs or fins arranged in a pattern - such as herringbone, alternate directions, zig-zag or other -, coils, balls, twisted wire rod, as steel wool or other or any combination thereof.

During the connection process the object 1 will deform the turbulator 5 and force it into the cavity 2. Since the height H of the turbulator 5 is only reduced by approximately 6% in this embodiment, when the object 1 compresses the turbulator 5, and given the design of the turbulator 5, the turbulator 5 is only subject to elastic deformation in this embodiment but in another embodiment the turbulator 5 could also be subject to plastic deformation.

Once the object 1 is tightly connected to the contact surface 4 a flow of cooling fluid is established through a cooling fluid channel (not shown) to direct cooling fluid through the cavity 2 and the turbulator 5 to cool the object 1.

Fig. 5 shows a cross section through a cooling device 14 with an intermediate plate 10, as seen from the front.

In this embodiment the object 1 comprises an intermediate plate 10 which is extending continuously across all the cavities 2 in the baseplate 3. However, in another embodiment at least some of the cavities 2 could be provided with individual intermediate plates 10. In this embodiment turbulators 5 are first arranged in the cavities 2 so that they extend slightly out of the cavities 2 - because they are higher than the depth D of the cavities 2. The intermediate plate 10 is then connected tightly to the contact surface 4 of the baseplate 3 by means of soldering and as the intermediate plate 10 is forced against the contact surface 4, the turbulators 5 are deformed and forced down into the cavities so that they are flush with the contact surface 4 and presses firmly against the intermediate plate 10.

However, in another embodiment the intermediate plate 10 could be connected to the contact surface 4 by means of adhesive, welding, bolts, rivets or other or any combination thereof.

In this embodiment the object 1 comprises power electronics 17 in the form of converters and in this embodiment the power electronics 17 is connected to the intermediate plate 10 by means of bolts after the intermediate plate 10 has been connected to the baseplate 3. Through this design the power electronics 17 can be replaced while the cavities 2 are still filled with cooling fluid. In another embodiment the power electronics 17 could be connected to the intermediate plate 10 before the intermediate plate 10 is connected to the baseplate 3 and the power electronics 17 could be connected to the intermediate plate 10 by means of other connection means 9 as previously exemplified.

Fig. 6 shows a cross section through a cooling device 14 with a gasket 6 on the object 1, as seen from the front.

In this embodiment a bottom part 7 of the object 1 is protruding from a contact face 8 at the underside of the object 1. Thus, in this embodiment the turbulator 5 is not formed to extend out of the cavity 2. In this embodiment the turbulator 5 is initially substantially flush with the contact surface 4 of the baseplate 3 but when the object 1 is connected, so that the contact face 8 of the object 1 is forced against the contact surface 4 of the baseplate 3, the protruding bottom part 7 of the object 1 is extending into the cavity 2 so that it deforms the turbulator 5 and forces the turbulator 5 into the cavity 2. In another embodiment the turbulator 5 could initially be formed with a hight H shorter than the depth D of the cavity 2 depending on the extend of the protruding bottom part 7 of the object 1.

Fig. 7 shows a cross section through a cooling device 14 with sloping edges 18 on the baseplate 3, as seen from the front.

In this embodiment the contact surface 4 is formed with sloping edges 18 around the cavity 2, wherein the edges 18 are sloping downwards towards the cavity 2 as indicated by the angular arrows on fig. 7. Thus, in this embodiment a turbulator 5 is initially formed with a hight H shorter than the depth D of the cavity 2 (where the depth D is measured from the contact surface 4 to the bottom of the cavity 2) and when the object 1 is connected to the sloping edges 18 of the contact surface 4, the object 1 will be bend a little so that at least the middle area of the object 1 will be forced against the turbulator 5 to deform it and press it down further into the cavity 2.

In the embodiment discloses in fig. 6 the object 1 is provided with an object groove 16 in which a gasket 6 is placed and in the embodiment disclosed in fig. 7 the baseplate 3 is provided with a baseplate groove 15 in which a gasket 6 is placed. Placing the gasket 6 in a groove 15, 16 simplifies assembly and ensures that the gasket 6 stays in the right place but in another embodiment the baseplate 3 and the object 1 would not be provided with grooves 15, 16 and the gasket 6 would be placed directly between the baseplate 3 and the object 1. In this embodiment the gasket 6 is an O-ring made from rubber but in another embodiment the gasket 6 could have another shape, such as oval, rectangular, flat, or other and/or the gasket 6 could be made in another material such as cobber, plastic, a composite material or other or the gasket 6 could be formed by a sealing paste.

In relation to figs. 3-7 different embodiments and methods for deforming the turbulator 5 and forcing it down into the cavity 2 by means of the object 1 is disclosed and discussed but further methods exist - such as by making the turbulator 5 extend out of the cavity 2 by initially placing a thin plate (not shown) in the bottom of the cavity 2, by placing a thin plate (not shown) on top of the turbulator 5 or in another way or any combination of the methods disclosed and discussed in relation to figs. 3-7.

Fig. 8 shows a cross section through a cooling device 14 with cooling paste 19 on the objects 1, as seen from the front.

In this embodiment the object 1 comprises an intermediate plate 10 as described in relation to fig. 5. In this embodiment the object 1 comprises power electronics 17 connected to the intermediate plate 10 and in this embodiment cooling paste 19 is initially applied to the underside of the power electronics 17 so that when the power electronics 17 is connected to the intermediate plate 10 the cooling paste 19 will ensure good heat conduction between the power electronics 17 and the intermediate plate 10.

Fig. 9 shows a cooling device 14 with continuous transverse cooling fluid flow, as seen from the top, Fig. 10 shows a cooling device 14 with continuous longitudinal cooling fluid flow, as seen from the top, Fig. 11 shows a cooling device 14 with individual transverse cooling fluid flow, as seen from the top, and Fig. 12 shows a cooling device 14 with cooling fluid inflow at the centre, as seen from the top. In all the embodiment in figs. 9-12 the cooling device 14 is disclosed without the objects 1 attached to the baseplate 3 so that the cavities 2 and the turbulators 5 are exposed.

In each of the embodiments disclosed in figs. 9-12 the cooling device 14 comprises a cooling fluid channel 11 having a cooling fluid inlet 12 and a cooling fluid outlet 13 enabling that a flow of cooling fluid can be established through all the cavities 2 in the baseplate 3 e.g. by means of an external pump (not shown). However, in another embodiment at least some of the cavities could comprise their own individual cooling fluid channel 11 e.g., to provide different cooling profiles to different objects 1.

In this embodiment the cooling fluid is a glycol and water solution but in another embodiment the cooling fluid could be brine, water, ammonia, or another form of natural or artificial cooling fluid suitable for exchanging heat with the objects 1 to cool the objects 1.

In the foregoing, the invention is described in relation to specific embodiments of objects 1, baseplates 3, turbulators 5 and other as shown in the drawings, but it is readily understood by a person skilled in the art that the invention can be varied in numerous ways within the scope of the appended claims.

### List

- 1.: Object
- 2.: Cavity
- 3.: Baseplate
- 4.: Connection surface
- 5.: Turbulator
- 6.: Gasket
- 7.: Bottom part of object
- 8.: Contact face of object
- 9.: Connection means
- 10.: Intermediate plate
- 11.: Cooling fluid channel
- 12.: Cooling fluid inlet
- 13.: Cooling fluid outlet
- 14.: Cooling device
- 15.: Baseplate groove
- 16.: Object grove
- 17.: Power electronics
- 18.: Sloping edges
- 19.: Cooling paste
- H.: Height of turbulator
- D.: depth of cavity

## Claims

1. A method for cooling at least one heat generating power electronics (17), wherein said method comprises the steps of
• forming at least one cavity (2) in a baseplate (3) so that said least one cavity (2) is extending from a connection surface (4) of said baseplate (3) and into said baseplate (3),
• arranging a turbulator (5) in said at least one cavity (2),
• connecting said at least one heat generating power electronics (17) to said connection surface (4) so that said at least one heat generating power electronics (17) deforms said turbulator (5) and forces said turbulator (5) into said cavity (2), and
• generating a flow of cooling fluid through said cavity (2) to cool said at least one heat generating power electronics (17),
**characterized in that**,
said turbulator (5) is extending out of said cavity (2) so that said at least one heat generating power electronics (17) deforms said turbulator (5) and forces said turbulator (5) into said cavity (2), or
at least a bottom part (7) of said at least one heat generating power electronics (17) is extending into said cavity (2), when said at least one heat generating power electronics (17) is connected to said connection surface (4), so that said bottom part (7) of said at least one heat generating power electronics (17) deforms said turbulator (5) and forces said turbulator (5) into said cavity (2).

2. A method according to claim 1, wherein said method further comprises the step of arranging a gasket (6) between said heat generating power electronics (17) and said baseplate (3).

3. A method according to claim 1 or 2, wherein said at least one heat generating power electronics (17) comprises a contact face (8) arranged to be connected to said connection surface (4) and wherein said bottom part (7) is protruding from said contact face (8).

4. A method according to any of the preceding claims, wherein said at least one heat generating power electronics (17) fully covers said at least one cavity (2) when said at least one heat generating power electronics (17) is connected to said connection surface (4).

5. A method according to any of the preceding claims, wherein said at least one heat generating power electronics (17) comprises an intermediate plate (10), wherein said method comprises the step of connecting said intermediate plate (10) to said connection surface (4) and subsequently connecting said power electronics (17) to said intermediate plate (10).

6. A method according to any of the preceding claims, wherein said at least one heat generating power electronics (17) deforms said turbulator (5) so that the height (H) of said turbulator (5) is reduced by between 0,1% and 30%, preferably between 0,5% and 20% and most preferred between 1% and 10%.

7. A method according to any of the preceding claims, wherein at least a part of said connection surface (4) is sloping downwards towards said at least one cavity (2) so that at least a part of said at least one heat generating power electronics (17) is bend in a downward arc, whereby said at least one heat generating power electronics (17) deforms said turbulator (5) and forces said turbulator (5) into said at least one cavity (2), when said at least one heat generating power electronics (17) is connected to said connection surface (4).

8. A cooling device (14) comprising
a baseplate (3) having at least one cavity (2) extending from a connection surface (4) of said baseplate (3) and into said baseplate (3) and wherein a cooling fluid channel (11) connects said at least one cavity (2) with a cooling fluid inlet (12) and a cooling fluid outlet (13) of said baseplate (3),
a turbulator (5) arranged in said at least one cavity (2), and
at least one heat generating power electronics (17) being connected to said connection surface (4) so that said at least one heat generating power electronics (17) deforms said turbulator (5) and forces said turbulator (5) into said cavity (2),
**characterized in that**,
said turbulator (5) is extending out of said cavity (2) so that said at least one heat generating power electronics (17) deforms said turbulator (5) and forces said turbulator (5) into said cavity (2) when said at least one heat generating power electronics (17) is connected to said connection surface (4), or
at least a bottom part (7) of said at least one heat generating power electronics (17) is extending into said cavity (2), when said at least one heat generating power electronics (17) is connected to said connection surface (4), so that said bottom part (7) of said at least one heat generating power electronics (17) deforms said turbulator (5) and forces said turbulator (5) into said cavity (2), when said at least one heat generating power electronics (17) is connected to said connection surface (4).

9. A cooling device (14) according to claim 8, wherein said at least one heat generating power electronics (17) deforms said turbulator (5) so that the height (H) of said turbulator (5) is reduced by between 0,1% and 30%, preferably between 0,5% and 20% and most preferred between 1% and 10% when said at least one heat generating power electronics (17) is connected to said connection surface (4).

10. A cooling device (14) according to claim 8 or 9, wherein the height (H) of said turbulator (5) is reduced between 0.1 and 2 millimeters when said at least one heat generating power electronics (17) is connected to said connection surface (4).

11. A cooling device (14) according to any of claims 8-10, wherein said cooling device (14) further comprises a gasket (6) encircling said at least one cavity (2) and wherein said gasket (6) is arranged in a baseplate groove (15) in said connection surface (4) or in an object grove (16) in said heat generating power electronics (17).

12. A cooling device (14) according to any of claims 8-11, wherein the hight (H) of said turbulator (5) is greater than the depth (D) of said at least one cavity (2) before said at least one heat generating power electronics (17) is connected to said connection surface (4).

13. A cooling device (14) according to any of claims 8-12, wherein at least a part of said connection surface (4) is sloping downwards towards said at least one cavity (2) so that at least a part of said at least one heat generating power electronics (17) is bend in a downward arc, whereby said at least one heat generating power electronics (17) deforms said turbulator (5) and forces said turbulator (5) into said at least one cavity (2), when said at least one heat generating power electronics (17) is connected to said connection surface (4).

14. A cooling device (14) according to any of claims 8-13, wherein said at least one heat generating power electronics (17) comprises an intermediate plate (10) and wherein said intermediate plate (10) is connected to said connection surface (4) and said power electronics (17) is connected to said intermediate plate (10).

15. A cooling device (14) according to claim 14, wherein said intermediate plate (10) is connected to said connection surface (4) by means of soldering.

## Patentansprüche

1. Verfahren zum Kühlen mindestens einer wärmeerzeugenden Leistungselektronik (17), wobei das Verfahren die Schritte umfasst
• Ausbilden mindestens einer Kavität (2) in einer Grundplatte (3), so dass sich die mindestens eine Kavität (2) von einer Verbindungsoberfläche (4) der Grundplatte (3) und in die Grundplatte (3) hinein erstreckt,
• Anordnen eines Turbulenzerzeugers (5) in der mindestens einen Kavität (2),
• Verbinden der mindestens einen wärmeerzeugenden Leistungselektronik (17) mit der Verbindungsoberfläche (4), so dass die mindestens eine wärmeerzeugende Leistungselektronik (17) den Turbulenzerzeuger (5) verformt und den Turbulenzerzeuger (5) in den Hohlraum (2) drückt, und
• Erzeugen eines Flusses von Kühlfluid durch die Kavität (2) hindurch, um die mindestens eine wärmeerzeugende Leistungselektronik (17) zu kühlen,
**dadurch gekennzeichnet, dass**
wobei sich der Turbulenzerzeuger (5) aus der Kavität (2) heraus erstreckt, so dass die mindestens eine wärmeerzeugende Leistungselektronik (17) den Turbulenzerzeuger (5) verformt und den Turbulenzerzeuger (5) in die Kavität (2) hineindrückt, oder
mindestens ein Bodenteil (7) der mindestens einen wärmeerzeugenden Leistungselektronik (17) sich in die Kavität (2) erstreckt, wenn die mindestens eine wärmeerzeugende Leistungselektronik (17) mit der Verbindungsoberfläche (4) verbunden ist, so dass der Bodenteil (7) der mindestens einen wärmeerzeugenden Leistungselektronik (17) den Turbulenzerzeuger (5) verformt und den Turbulenzerzeuger (5) in die Kavität (2) drückt.

2. Verfahren nach Anspruch 1, wobei das Verfahren ferner den Schritt des Anordnens einer Dichtung (6) zwischen der wärmeerzeugenden Leistungselektronik (17) und der Grundplatte (3) umfasst.

3. Verfahren nach Anspruch 1 oder 2, wobei die mindestens eine wärmeerzeugende Leistungselektronik (17) eine Kontaktfläche (8) umfasst, die angeordnet ist, um mit der Verbindungsoberfläche (4) verbunden zu werden, und wobei das Bodenteil (7) von der Kontaktfläche (8) vorsteht.

4. Verfahren nach einem der vorstehenden Ansprüche, wobei die mindestens eine wärmeerzeugende Leistungselektronik (17) den mindestens einen Hohlraum (2) vollständig abdeckt, wenn die mindestens eine wärmeerzeugende Leistungselektronik (17) mit der Verbindungsoberfläche (4) verbunden ist.

5. Verfahren nach einem der vorstehenden Ansprüche, wobei die mindestens eine wärmeerzeugende Leistungselektronik (17) eine Zwischenplatte (10) umfasst, wobei das Verfahren den Schritt des Verbindens der Zwischenplatte (10) mit der Verbindungsoberfläche (4) und anschließendes Verbinden der Leistungselektronik (17) mit der Zwischenplatte (10) umfasst.

6. Verfahren nach einem der vorstehenden Ansprüche, wobei die mindestens eine wärmeerzeugende Leistungselektronik (17) den Turbulenzerzeuger (5) verformt, so dass die Höhe (H) des Turbulenzerzeugers (5) um zwischen 0,1 % und 30 %, vorzugsweise zwischen 0,5 % und 20 % und am meisten bevorzugt zwischen 1 % und 10 % reduziert wird.

7. Verfahren nach einem der vorstehenden Ansprüche, wobei mindestens ein Teil der Verbindungsoberfläche (4) nach unten zu der mindestens einen Kavität (2) hin geneigt ist, so dass mindestens ein Teil der mindestens einen wärmeerzeugenden Leistungselektronik (17) in einem nach unten gerichteten Bogen gebogen ist, wodurch die mindestens eine wärmeerzeugende Leistungselektronik (17) den Turbulenzerzeuger (5) verformt und den Turbulenzerzeuger (5) in die mindestens eine Kavität (2) drückt, wenn die mindestens eine wärmeerzeugende Leistungselektronik (17) mit der Verbindungsoberfläche (4) verbunden ist.

8. Kühlvorrichtung (14), umfassend
eine Grundplatte (3), die mindestens einem Hohlraum (2) aufweist, der sich von einer Verbindungsoberfläche (4) der Grundplatte (3) und in die Grundplatte (3) hinein erstreckt, und wobei ein Kühlfluidkanal (11) den mindestens einen Hohlraum (2) mit einem Kühlfluideinlass (12) und einem Kühlfluidauslass (13) der Grundplatte (3) verbindet,
einen Turbulenzerzeuger (5), der in der mindestens einen Kavität (2) angeordnet ist, und
mindestens eine wärmeerzeugende Leistungselektronik (17), die mit der Verbindungsoberfläche (4) verbunden ist, so dass die mindestens eine wärmeerzeugende Leistungselektronik (17) den Turbulenzerzeuger (5) verformt und den Turbulenzerzeuger (5) in den Hohlraum (2) drückt,
**dadurch gekennzeichnet, dass**
wobei sich der Turbulenzerzeuger (5) aus der Kavität (2) heraus erstreckt, so dass die mindestens eine wärmeerzeugende Leistungselektronik (17) den Turbulenzerzeuger (5) verformt und den Turbulenzerzeuger (5) in die Kavität (2) hineindrückt, wenn die mindestens eine wärmeerzeugende Leistungselektronik (17) mit der Verbindungsoberfläche (4) verbunden ist, oder
mindestens ein Bodenteil (7) der mindestens einen wärmeerzeugenden Leistungselektronik (17) sich in den Hohlraum (2) erstreckt, wenn die mindestens eine wärmeerzeugende Leistungselektronik (17) mit der Verbindungsoberfläche (4) verbunden ist, so dass der Bodenteil (7) der mindestens einen wärmeerzeugenden Leistungselektronik (17) den Turbulenzerzeuger (5) verformt und den Turbulenzerzeuger (5) in den Hohlraum (2) drückt, wenn die mindestens eine wärmeerzeugende Leistungselektronik (17) mit der Verbindungsoberfläche (4) verbunden ist.

9. Kühlvorrichtung (14) nach Anspruch 8, wobei die mindestens eine wärmeerzeugende Leistungselektronik (17) den Turbulenzerzeuger (5) verformt, so dass die Höhe (H) des Turbulenzerzeugers (5) um zwischen 0,1 % und 30 %, vorzugsweise zwischen 0,5 % und 20 % und am meisten bevorzugt zwischen 1 % und 10 % reduziert wird, wenn die mindestens eine wärmeerzeugende Leistungselektronik (17) mit der Verbindungsoberfläche (4) verbunden ist.

10. Kühlvorrichtung (14) nach Anspruch 8 oder 9, wobei die Höhe (H) des Turbulenzerzeugers (5) um 0,1 bis 2 Millimeter reduziert wird, wenn die mindestens eine wärmeerzeugende Leistungselektronik (17) mit der Verbindungsoberfläche (4) verbunden ist.

11. Kühlvorrichtung (14) nach einem der Ansprüche 8 bis 10, wobei die Kühlvorrichtung (14) ferner eine Dichtung (6) umfasst, die den mindestens einen Hohlraum (2) umgibt, und wobei die Dichtung (6) in einer Grundplattennut (15) in der Verbindungsoberfläche (4) oder in einer Objektnut (16) in der wärmeerzeugenden Leistungselektronik (17) angeordnet ist.

12. Kühlvorrichtung (14) nach einem der Ansprüche 8 bis 11, wobei die Höhe (H) des Turbulenzerzeugers (5) größer als die Tiefe (D) der mindestens einen Kavität (2) ist, bevor die mindestens eine wärmeerzeugende Leistungselektronik (17) mit der Verbindungsoberfläche (4) verbunden wird.

13. Kühlvorrichtung (14) nach einem der Ansprüche 8 bis 12, wobei mindestens ein Teil der Verbindungsoberfläche (4) nach unten zu der mindestens einen Kavität (2) hin geneigt ist, so dass mindestens ein Teil der mindestens einen wärmeerzeugenden Leistungselektronik (17) in einem nach unten gerichteten Bogen gebogen ist, wodurch die mindestens eine wärmeerzeugende Leistungselektronik (17) den Turbulenzerzeuger (5) verformt und den Turbulenzerzeuger (5) in die mindestens eine Kavität (2) drückt, wenn die mindestens eine wärmeerzeugende Leistungselektronik (17) mit der Verbindungsoberfläche (4) verbunden ist.

14. Kühlvorrichtung (14) nach einem der Ansprüche 8 bis 13, wobei die mindestens eine wärmeerzeugende Leistungselektronik (17) eine Zwischenplatte (10) umfasst und wobei die Zwischenplatte (10) mit der Verbindungsoberfläche (4) verbunden ist und die Leistungselektronik (17) mit der Zwischenplatte (10) verbunden ist.

15. Kühlvorrichtung (14) nach Anspruch 14, wobei die Zwischenplatte (10) mit der Verbindungsoberfläche (4) mittels Löten verbunden ist.

## Revendications

1. Procédé de refroidissement d'au moins une électronique de puissance génératrice de chaleur (17), dans lequel ledit procédé comprend les étapes consistant à
• former au moins une cavité (2) dans une plaque de base (3) de sorte que ladite au moins une cavité (2) s'étend à partir d'une surface de liaison (4) de ladite plaque de base (3) et dans ladite plaque de base (3),
• agencer un turbulateur (5) dans ladite au moins une cavité (2),
• relier ladite au moins une électronique de puissance génératrice de chaleur (17) à ladite surface de liaison (4) de sorte que ladite au moins une électronique de puissance génératrice de chaleur (17) déforme ledit turbulateur (5) et force ledit turbulateur (5) à entrer dans ladite cavité (2), et
• générer un flux de fluide de refroidissement à travers ladite cavité (2) pour refroidir ladite au moins une électronique de puissance génératrice de chaleur (17),
**caractérisé en ce que,**
ledit turbulateur (5) s'étend hors de ladite cavité (2) de sorte que ladite au moins une électronique de puissance génératrice de chaleur (17) déforme ledit turbulateur (5) et force ledit turbulateur (5) à entrer dans ladite cavité (2), ou
au moins une partie inférieure (7) de ladite au moins une électronique de puissance génératrice de chaleur (17) s'étend dans ladite cavité (2), lorsque ladite au moins une électronique de puissance génératrice de chaleur (17) est reliée à ladite surface de liaison (4), de sorte que ladite partie inférieure (7) de ladite au moins une électronique de puissance génératrice de chaleur (17) déforme ledit turbulateur (5) et force ledit turbulateur (5) dans ladite cavité (2).

2. Procédé selon la revendication 1, dans lequel ledit procédé comprend en outre l'étape consistant à agencer un joint (6) entre ladite électronique de puissance génératrice de chaleur (17) et ladite plaque de base (3).

3. Procédé selon la revendication 1 ou 2, dans lequel ladite au moins une électronique de puissance génératrice de chaleur (17) comprend une face de contact (8) agencée pour être reliée à ladite surface de liaison (4) et dans lequel ladite partie inférieure (7) fait saillie à partir de ladite face de contact (8).

4. Procédé selon l'une quelconque des revendications précédentes, dans lequel ladite au moins une électronique de puissance génératrice de chaleur (17) couvre entièrement ladite au moins une cavité (2) lorsque ladite au moins une électronique de puissance génératrice de chaleur (17) est reliée à ladite surface de liaison (4).

5. Procédé selon l'une quelconque des revendications précédentes, dans lequel ladite au moins une électronique de puissance génératrice de chaleur (17) comprend une plaque intermédiaire (10), dans lequel ledit procédé comprend l'étape consistant à relier ladite plaque intermédiaire (10) à ladite surface de liaison (4) et à relier ensuite ladite électronique de puissance (17) à ladite plaque intermédiaire (10).

6. Procédé selon l'une quelconque des revendications précédentes, dans lequel ladite au moins une électronique de puissance génératrice de chaleur (17) déforme ledit turbulateur (5) de sorte que la hauteur (H) dudit turbulateur (5) est réduite entre 0,1 % et 30 %, de préférence entre 0,5 % et 20 % et le plus préférablement entre 1 % et 10 %.

7. Procédé selon l'une quelconque des revendications précédentes, dans lequel au moins une partie de ladite surface de liaison (4) est inclinée vers le bas vers ladite au moins une cavité (2) de sorte qu'au moins une partie de ladite au moins une électronique de puissance génératrice de chaleur (17) est pliée dans un arc vers le bas, moyennant quoi ladite au moins une électronique de puissance génératrice de chaleur (17) déforme ledit turbulateur (5) et force ledit turbulateur (5) dans ladite au moins une cavité (2), lorsque ladite au moins une électronique de puissance génératrice de chaleur (17) est liée à ladite surface de liaison (4).

8. Dispositif de refroidissement (14) comprenant
une plaque de base (3) ayant au moins une cavité (2) s'étendant à partir d'une surface de liaison (4) de ladite plaque de base (3) et dans ladite plaque de base (3) et dans laquelle un canal de fluide de refroidissement (11) relie ladite au moins une cavité (2) à une entrée de fluide de refroidissement (12) et à une sortie de fluide de refroidissement (13) de ladite plaque de base (3),
un turbulateur (5) agencé dans ladite au moins une cavité (2), et
au moins une électronique de puissance génératrice de chaleur (17) étant reliée à ladite surface de liaison (4) de sorte que ladite au moins une électronique de puissance génératrice de chaleur (17) déforme ledit turbulateur (5) et force ledit turbulateur (5) à entrer dans ladite cavité (2),
**caractérisé en ce que,**
ledit turbulateur (5) s'étend hors de ladite cavité (2) de sorte que ladite au moins une électronique de puissance génératrice de chaleur (17) déforme ledit turbulateur (5) et force ledit turbulateur (5) dans ladite cavité (2) lorsque ladite au moins une électronique de puissance génératrice de chaleur (17) est reliée à ladite surface de liaison (4), ou
au moins une partie inférieure (7) de ladite au moins une électronique de puissance génératrice de chaleur (17) s'étend dans ladite cavité (2), lorsque ladite au moins une électronique de puissance génératrice de chaleur (17) est reliée à ladite surface de liaison (4), de sorte que ladite partie inférieure (7) de ladite au moins une électronique de puissance génératrice de chaleur (17) déforme ledit turbulateur (5) et force ledit turbulateur (5) dans ladite cavité (2), lorsque ladite au moins une électronique de puissance génératrice de chaleur (17) est reliée à ladite surface de liaison (4).

9. Dispositif de refroidissement (14) selon la revendication 8, dans lequel ladite au moins une électronique de puissance génératrice de chaleur (17) déforme ledit turbulateur (5) de sorte que la hauteur (H) dudit turbulateur (5) est réduite entre 0,1 % et 30 %, de préférence entre 0,5 % et 20 % et le plus préférablement entre 1 % et 10 % lorsque ladite au moins une électronique de puissance génératrice de chaleur (17) est reliée à ladite surface de liaison (4).

10. Dispositif de refroidissement (14) selon la revendication 8 ou 9, dans lequel la hauteur (H) dudit turbulateur (5) est réduite entre 0,1 et 2 millimètres lorsque ladite au moins une électronique de puissance génératrice de chaleur (17) est reliée à ladite surface de liaison (4).

11. Dispositif de refroidissement (14) selon l'une quelconque des revendications 8 à 10, dans lequel ledit dispositif de refroidissement (14) comprend en outre un joint (6) entourant ladite au moins une cavité (2) et dans lequel ledit joint (6) est agencé dans une rainure de plaque de base (15) dans ladite surface de liaison (4) ou dans une rainure d'objet (16) dans ladite électronique de puissance génératrice de chaleur (17).

12. Dispositif de refroidissement (14) selon l'une quelconque des revendications 8 à 11, dans lequel la hauteur (H) dudit turbulateur (5) est supérieure à la profondeur (D) de ladite au moins une cavité (2) avant que ladite au moins une électronique de puissance génératrice de chaleur (17) ne soit reliée à ladite surface de liaison (4).

13. Dispositif de refroidissement (14) selon l'une quelconque des revendications 8 à 12, dans lequel au moins une partie de ladite surface de liaison (4) est inclinée vers le bas vers ladite au moins une cavité (2) de sorte qu'au moins une partie de ladite au moins une électronique de puissance génératrice de chaleur (17) est pliée dans un arc vers le bas, moyennant quoi ladite au moins une électronique de puissance génératrice de chaleur (17) déforme ledit turbulateur (5) et force ledit turbulateur (5) dans ladite au moins une cavité (2), lorsque ladite au moins une électronique de puissance génératrice de chaleur (17) est reliée à ladite surface de liaison (4).

14. Dispositif de refroidissement (14) selon l'une quelconque des revendications 8 à 13, dans lequel ladite au moins une électronique de puissance génératrice de chaleur (17) comprend une plaque intermédiaire (10) et dans lequel ladite plaque intermédiaire (10) est reliée à ladite surface de liaison (4) et ladite électronique de puissance (17) est reliée à ladite plaque intermédiaire (10).

15. Dispositif de refroidissement (14) selon la revendication 14, dans lequel ladite plaque intermédiaire (10) est reliée à ladite surface de liaison (4) au moyen d'une soudure.
